# EUROPÄISCHE PATENTSCHRIFT

(11) **EP 3 374 542 B1**
(45) Veröffentlichungstag und Bekanntmachung des Hinweises auf die Patenterteilung: **15.07.2020**
(21) Anmeldenummer: 16787428.8
(22) Anmeldetag: 25.10.2016
(51) Int. Cl.: C23C 16/513, H05H 1/34, B05B 7/00, B05B 7/22

(54) **VORRICHTUNG ZUM AUFBRINGEN EINER BESCHICHTUNG**
DEVICE FOR APPLYING A COATING
DISPOSITIF D'APPLICATION D'UN REVÊTEMENT

(30) Priorität: 12.11.2015 AT 509682015
(43) Veröffentlichungstag der Anmeldung: 19.09.2018
(73) Patentinhaber: Inocon Technologie Gesellschaft m.b.H, 4800 Attnang-Puchheim (AT)
(72) Erfinder: PESENDORFER, Friedrich, 1230 Wien (AT)
(74) Vertreter: KLIMENT & HENHAPEL
(86) Internationale Anmeldenummer: PCT/EP2016/075653
(87) Internationale Veröffentlichungsnummer: WO 2017/080815

(56) Entgegenhaltungen:
- WO-A2-00/55388
- JP-A- 2000 178 744
- US-A- 5 538 765
- US-B1- 6 800 336

## Beschreibung

Die Erfindung betrifft eine Vorrichtung zum Aufbringen einer Beschichtung auf eine Oberfläche eines Substrats mit einem Plasmaerzeuger umfassend eine Anode und eine Kathode zum Erzeugen eines atmosphärischen Plasmastrahls durch elektrische Entladung in einem Arbeitsgas, wobei eine Zufuhreinrichtung mit einer Einlassseite zum Beschicken der Zufuhreinrichtung mit einem Beschichtungsmaterial und einer Auslassseite zum Einbringen des Beschichtungsmaterials in den Plasmastrahl vorgesehen ist, und die Zufuhreinrichtung einlassseitig mit einem Verdampfer für das Beschichtungsmaterial verbunden ist und auslassseitig eine Austrittsöffnung für das gasförmige Beschichtungsmaterial aufweist, gemäß dem Oberbegriff von Anspruch 1.

Unter einem atmosphärischen Plasmastrahl wird ein Plasmastrahl mit einem Umgebungsdruck, der in der Größenordnung des Atmosphärendrucks liegt, bezeichnet. Zur Bildung eines solchen Plasmastrahls wird ein Arbeitsgas, zumeist Luft, Stickstoff oder ein Edelgas, durch einen Kanal geführt, in dem mittels Hochspannung eine elektrische Entladung in Form einer Koronaentladung und/oder einer Bogenentladung erzeugt wird, die das Arbeitsgas ionisiert und einen Plasmastrahl im Kanal bildet. Dem Plasmastrahl kann in weiterer Folge ein Beschichtungsmaterial zugeführt werden, um ein Substrat entsprechend zu beschichten, auf das der mit dem Beschichtungsmaterial vermengte Plasmastrahl gerichtet wird.

Als Beschichtungsmaterial sind beispielsweise pulverförmige Beschichtungsmaterialien in Form von Metallverbindungen oder Thermoplasten bekannt, die dem Plasmastrahl über einen Pulverförderer zumeist mittels eines Trägergases zugeführt werden, im Plasmastrahl aufschmelzen und im schmelzflüssigen oder teigigen Zustand durch die Volumensexpansion des Plasmastrahls beschleunigt und auf das zu beschichtende Substrat abgeschieden werden. Die Schichtdicken bewegen sich dabei vom einstelligen Mikrometerbereich bis in den Millimeterbereich. Bekannte Anwendungen sind etwa die Herstellung hochverschleißfester Schichten auf Basis von Wolframkarbid.

Ferner sind flüssige Beschichtungsmaterialien bekannt, die in flüssiger Form dem Plasmastrahl zugeführt werden und auch als "Precursor" bezeichnet werden. Ein solches Verfahren ist etwa aus der US 6,800,336 B1 bekannt.

Das dem Plasmastrahl zugeführte Beschichtungsmaterial erfährt im Plasmastrahl chemische und/oder physikalische Veränderungen, die die Eigenschaften der auf dem Substrat gebildeten Schicht entscheidend beeinflussen können. So sind etwa manche der bekannten Beschichtungsmaterialien oxidationsempfindlich und können durch Reaktion mit dem Sauerstoff der umgebenden Atmosphäre oxidieren. Andere Beschichtungsmaterialien sind hydrolyseempfindlich und reagieren mit vorhandenem Wasser auf unerwünschte Weise, bevor sie auf dem Substrat abgeschieden werden. Ungewollte oder unkontrollierbare Modifikationen des Beschichtungsmaterials chemischer und/oder physikalischer Art vermindern jedoch die Beschichtungsqualität, indem gewünschte Schichteigenschaften entweder nicht zuverlässig reproduziert werden können, oder innerhalb derselben Schicht variieren und zu einem inhomogenen Schichtaufbau der betreffenden Schicht führen. Die Beschichtung sollte jedoch möglichst homogen und in ihren Eigenschaften möglichst zuverlässig reproduzierbar sein.

Daher wurde auch vorgeschlagen, den Beschichtungsvorgang unter Vakuum oder zumindest einem gegenüber dem Atmosphärendruck stark verminderten Druck durchzuführen, um chemische Veränderungen des Beschichtungsmaterials bis zum Auftreffen auf die Substratoberfläche zu reduzieren, insbesondere dessen Oxidation. Ein solches Verfahren ist etwa aus der US 5,538,765 B1 und der JP 2000 178744 sowie der WO 00 553 88 A2, die als nächstkommender Stand der Technik aufgefasst wird, bekannt. Die Beschichtung unter Vakuum erhöht aber deutlich den apparativen Aufwand uns somit die Kosten und den Zeitaufwand des Beschichtungsvorganges.

Es besteht daher das Ziel der vorliegenden Erfindung darin, das Aufbringen einer Schicht auf einer Oberfläche mittels eines Plasmastrahls unter atmosphärischen Bedingungen zu verbessern und insbesondere die funktionalen Eigenschaften der Beschichtung homogener und besser kontrollierbar zu gestalten.

Diese Ziele werden durch die Merkmale von Anspruch 1 erreicht. Anspruch 1 bezieht sich auf eine Vorrichtung zum Aufbringen einer Beschichtung auf eine Oberfläche eines Substrats mit einem Plasmaerzeuger umfassend eine Anode und eine Kathode zum Erzeugen eines atmosphärischen Plasmastrahls durch elektrische Entladung in einem Arbeitsgas, wobei eine Zufuhreinrichtung mit einer Einlassseite zum Beschicken der Zufuhreinrichtung mit einem Beschichtungsmaterial und einer Auslassseite zum Einbringen des Beschichtungsmaterials in den Plasmastrahl vorgesehen ist, und die Zufuhreinrichtung einlassseitig mit einem Verdampfer für das Beschichtungsmaterial verbunden ist und auslassseitig eine Austrittsöffnung für das gasförmige Beschichtungsmaterial aufweist. Erfindungsgemäß wird hierbei vorgeschlagen, dass der Plasmaerzeuger einen Austrittskanal für den Plasmastrahl aufweist, der sich über eine Ausströmöffnung zur umgebenden Atmosphäre öffnet, an die sich ein Ausströmbereich des in die umgebende Atmosphäre austretenden Plasmastrahls anschließt, und die Zufuhreinrichtung als zumindest ein Zufuhrrohr ausgeführt ist, dessen Austrittsöffnung in den Ausströmbereich gerichtet und innerhalb des Plasmastrahls positioniert ist.

Aufgrund des Verdampfens des Beschichtungsmaterials vor der Zufuhr zum Plasmastrahl kann eine homogenere Abscheidung auf dem Substrat insbesondere hinsichtlich der Partikelgröße des abgeschiedenen Materials erreicht werden. Zudem gelingt die Abscheidung dünnerer Schichten mit Schichtdicken bis in den einstelligen Nanometerbereich.

Entscheidend ist ferner, dass die Austrittsöffnung für das gasförmige Beschichtungsmaterial in den Ausströmbereich gerichtet ist. In herkömmlicher Weise wird das Beschichtungsmaterial über einen Zufuhrkanal in einen den Plasmastrahl führenden Austrittskanal eingeleitet, bevor der Plasmastrahl den Austrittskanal verlässt, also in Ausströmrichtung des Plasmastrahls gesehen vor der Ausströmöffnung des Austrittskanals und somit auch vor dem Ausströmbereich. In der Praxis führt diese Vorgangsweise zu unerwünschten Ablagerungen des Beschichtungsmaterials im Austrittskanal des Plasmastrahls, die nicht nur zu geringeren Standzeiten des Plasmaerzeugers führen können, sondern auch den Plasmastrahl ungünstig beeinflussen, wodurch die Beschichtungsqualität nicht reproduzierbar wird oder eine Schichtabscheidung gänzlich unmöglich wird. Durch die Zufuhr des Beschichtungsmaterials in den Ausströmbereich, also in jenen Bereich, in dem der Plasmastrahl in die umgebende Atmosphäre austritt, ergibt sich außerdem die Möglichkeit, die Zufuhr des Beschichtungsmaterials zum Plasmastrahl in örtlicher Hinsicht zu variieren. Der Plasmastrahl ändert sich nämlich bei Austritt in die umgebende Atmosphäre in Abhängigkeit vom Abstand zur Ausströmöffnung in chemischer und/oder physikalischer Hinsicht. So kühlt er etwa zunehmend ab und erfährt chemische Modifikationen durch Reaktion mit der umgebenden Luft. Diese Veränderungen können für eine Steuerung der funktionalen Schichteigenschaften gezielt ausgenutzt werden, indem das Beschichtungsmaterial in unterschiedliche Regionen des Ausströmbereiches eingeleitet wird. Wird es etwa nahe der Ausströmöffnung in den Ausströmbereich eingeleitet, also in einen Bereich hoher Plasmatemperatur und hohem Ionisierungsgrad des Plasmagases, wird das Beschichtungsmaterial stärker ionisiert als wenn es mit zunehmendem Abstand zur Ausströmöffnung in den Ausströmbereich eingeleitet wird, wo die Plasmatemperatur und der Ionisierungsgrad zunehmend abnehmen. Durch den veränderbaren Ionisierungsgrad wird das Beschichtungsmaterial beeinflusst und die Oberflächeneigenschaft kann gezielt eingestellt werden. Bei einer herkömmlichen Zufuhr des Beschichtungsmaterials in den Austrittskanal des Plasmaerzeugers besteht diese Möglichkeit der Variation des Zuführbereiches in den Plasmastrahl nicht, sodass auch nicht die unterschiedlichen Eigenschaften des Plasmastrahls ausgenutzt werden können. Mithilfe einer erfindungsgemäßen Zufuhr des Beschichtungsmaterials in den Ausströmbereich wird hingegen nicht nur eine gezielte Steuerung der Eigenschaften des abgeschiedenen Beschichtungsmaterials ermöglicht, sondern auch eine höhere Homogenität der Beschichtung, da Ablagerungen im Austrittskanal und chemische und/oder physikalische Reaktionen mit diesen Ablagerungen und der Grenzfläche des Austrittskanals vermieden werden.

Eine vorteilhafte apparativer Ausführung besteht dabei auch darin, die Zufuhreinrichtung als zumindest ein Zufuhrrohr auszuführen, das auf einer Halterung am Plasmaerzeuger befestigt ist. Die Austrittsöffnung des Zufuhrrohres ist dabei in den Ausströmbereich gerichtet. Zumeist sind Plasmaerzeuger, die für einen Beschichtungsvorgang verwendet werden, mit einem eigenen Beschichtungskopf versehen, der die Zufuhreinrichtung für das Beschichtungsmaterial enthält und einen Austrittskanal für das Plasma aufweist. Im Rahmen dieser Erfindung kann eine am Plasmaerzeuger befestigte Halterung mit einem Austrittskanal für das Plasma vorgesehen sein, wobei an der Außenseite der Halterung zumindest ein Zufuhrrohr für das Beschichtungsmaterial befestigt werden kann.

Vorzugsweise ist das Zufuhrrohr an der Halterung verstellbar befestigt, sodass die Positionierung der Austrittsöffnung innerhalb des Ausströmbereiches verändert werden kann und insbesondere gezielt eingestellt werden kann. Diese Positionierung kann dabei in vertikaler Richtung, in einer Horizontalebene, oder auch in seinem Winkel zur Ausströmrichtung des Plasmagases verändert werden. Diese gezielte Einstellung wird dabei wohl zumeist vom Hersteller des Plasmaerzeugers in Abhängigkeit der gewünschten Schichteigenschaften vorgenommen werden, aber vom Kunden und Anwender nicht mehr verändert werden. Insbesondere wird auch vorgeschlagen, dass die durch die Längsachse des Zufuhrrohres definierte Zufuhrrichtung des Beschichtungsmaterials in einem spitzen Winkel zur Ausströmrichtung des Plasmagases, die durch die Längsachse des Austrittskanals definiert ist, angeordnet ist. Durch diese Anordnung kann das Beschichtungsmaterial auch in Regionen des Ausströmbereiches eingeleitet werden, die von der Ausströmöffnung bereits weiter entfernt sind.

Als Arbeitsgas kann beispielsweise ein inertes Arbeitsgas verwendet werden. Auf diese Weise soll erreicht werden, dass das Arbeitsgas auf seinem Weg vom Bereich der Korona- und/oder Bogenentladung, wo es hochgradig ionisiert wird, bis zur Ausströmöffnung möglichst geringe chemische Veränderungen erfährt, da ansonsten die gezielte Steuerung der Schichteigenschaften durch örtlich kontrollierte Einleitung des Beschichtungsmaterials beeinträchtigt wird. Durch Verwendung eines inerten Arbeitsgases kann der physikalische und/oder chemische Zustand des Plasmastrahls im Ausströmbereich besser reproduziert und gesteuert werden. Des Weiteren mindert die Verwendung eines vorzugsweise inerten Arbeitsgases auch den Kathodenabbrand und erhöht die Standzeit des Plasmaerzeugers.

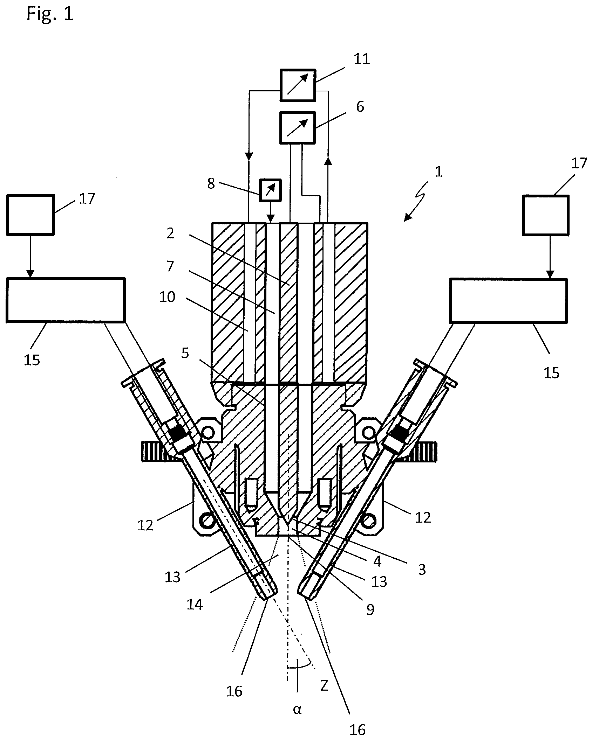

Die Erfindung wird in weiterer Folge anhand eines Ausführungsbeispiels mithilfe der beiliegenden Figuren näher erläutert. Es zeigt hierbei die
Fig. 1 eine Schnittansicht durch einen Plasmaerzeuger mit einer Ausführungsform einer erfindungsgemäßen Anordnung der Zufuhreinrichtung für Beschichtungsmaterial.

Im Folgenden wird anhand der Fig. 1 eine mögliche Ausführungsform einer erfindungsgemäßen Vorrichtung zum Aufbringen einer Beschichtung auf eine Oberfläche eines Substrats. Die Vorrichtung umfasst einen Plasmaerzeuger 1, der eine Kathode 2 und eine Anode 5 aufweist. Die Kathode 2 ist zylindrisch ausgeführt und weist an ihrem freien Ende einen konischen Endbereich 3 auf, der im gezeigten Ausführungsbeispiel in einen Austrittskanal 4 für den Plasmastrahl ragt. Die Anode 5 ist koaxial zur Kathode 2 angeordnet, wobei die Kathode 2 und die Anode 5 mit einer steuerbaren Spannungsquelle 6 verbunden sind. Zwischen der Kathode 2 und der Anode 5 wird eine Gleichspannung im Bereich von 10-30 V oder gepulste Spannung bis 5 kV bei einem Strom von 3-500 A oder gepulstem Strom von 0,1 A bis 2 A angelegt. Die elektrische Leistung des Plasmaerzeugers bewegt sich dabei im Bereich von 100-10000 W. Die Kathode 2 kann wahlweise in ihrem Inneren mit einer Kathodenkühlung (in der Fig. 1 nicht dargestellt) versehen sein. Des Weiteren sind im Mantelkörper des Plasmaerzeugers 1 Kühlmittelkanäle 10 vorgesehen, die mit einer Kühlmittelquelle 11 verbunden sind und den Plasmaerzeuger 1 kühlen.

Die Kathode 2 und die Anode 5 begrenzen einen Arbeitsgaskanal 7, der mit einer steuerbaren Arbeitsgasquelle 8 verbunden ist. Als Arbeitsgas können beispielsweise Argon, Helium, Stickstoff oder vorrangig inerte Mischgase wie etwa Argon-Wasserstoff-Mischgase oder auch Luft verwendet werden. Der Arbeitsgaskanal 7 mündet in den Austrittskanal 4, der sich über eine Ausströmöffnung 9 in die umgebende Atmosphäre öffnet. Im Betrieb wird an die Kathode 2 und die Anode 5 eine Spannung angelegt, die ausreichend hoch gewählt ist um zwischen dem spitz zulaufenden Endbereich der Kathode 2 und der die Kathode 2 umgebenden Anode 5 einen Lichtbogen zu zünden. Diese elektrische Entladung ionisiert das den Arbeitskanal 7 durchströmende Arbeitsgas, das in weiterer Folge als Plasma den Austrittskanal 4 durchströmt und als Plasmastrahl über die Ausströmöffnung 9 in die umgebende Atmosphäre austritt. Der an die Ausströmöffnung 9 angrenzende Atmosphärenbereich wird dabei in weiterer Folge als Ausströmbereich 14 bezeichnet und wird in der Fig. 1 mit punktierten Linien angedeutet. Die Ausströmweite des Plasmastrahls in der umgebenden Atmosphäre hängt insbesondere vom Betriebsdruck der Arbeitsgasquelle 8 und des angelegten Stromes an Kathode 2 und Anode 5 ab. Der Plasmastrahl erfährt während seines Strömungsweges entlang der Ausströmweite physikalische und chemische Veränderungen, insbesondere nehmen Temperatur und Ionisationsgrad mit zunehmendem Abstand von der Ausströmöffnung 9 ab. Zudem erfolgt eine zunehmende Vermengung mit den chemischen Bestandteilen der umgebenden Atmosphäre, die in den Randbereichen des Plasmastrahls größer ist als in seiner Kernzone.

Am Plasmaerzeuger 1 ist an seinem ausströmseitigen Ende ferner eine Halterung 12 angeordnet, über die eine Zufuhreinrichtung für Beschichtungsmaterial befestigt ist. Die Zufuhreinrichtung umfasst im gezeigten Ausführungsbeispiel zwei Zufuhrrohre 13, die einlassseitig mit einem Verdampfer 15 für das Beschichtungsmaterial verbunden sind und auslassseitig jeweils eine Austrittsöffnung 16 für das gasförmige Beschichtungsmaterial aufweisen, die in den Ausströmbereich 14 gerichtet sind. Der Verdampfer 15 ist mit zumindest einem Vorratsbehälter 17 für das Beschichtungsmaterial verbunden. Wie in der Fig. 1 ersichtlich ist, kann das Zufuhrrohr 13 so an der Halterung 12 befestigt werden, dass die durch die Längsachse des Zufuhrrohres 13 definierte Zufuhrachse Z des Beschichtungsmaterials in einem schrägen Winkel α zur Längsachse des Austrittskanals 4 angeordnet ist. Dieser Winkel kann herstellerseitig leicht verändert werden und so gewählt werden, dass die Zufuhr des Beschichtungsmaterials in unterschiedliche Regionen des austretenden Plasmastrahls vorgenommen werden kann, da sich die Positionierung der Austrittsöffnung 16 des Zufuhrrohres 13 innerhalb des Plasmastrahls bei verändertem Befestigungswinkel ändert. Diese unterschiedlichen Positionierungen der Austrittsöffnung 16 in den drei Raumrichtungen können für eine Steuerung der funktionalen Schichteigenschaften des abgeschiedenen Beschichtungsmaterials verwendet werden. Wird es etwa bei annähernd rechtem Winkel α zwischen der Zufuhrachse Z und der Längsachse des Austrittskanals 4 nahe der Ausströmöffnung 9 in den Ausströmbereich 14 eingeleitet, also in einen Bereich hoher Plasmatemperatur und hohem Ionisationsgrad, wird das Beschichtungsmaterial auf andere Weise angeregt als wenn es mit zunehmendem Abstand zur Ausströmöffnung 9 in den Ausströmbereich 14 eingeleitet wird, wo die Plasmatemperatur und der Ionisationsgrad zunehmend abnehmen. Die Positionierung der Austrittsöffnung 16 des Zufuhrrohres 13 innerhalb des Plasmastrahls kann aber auch anwenderseitig verändert werden, etwa um während wiederholter Beschichtungsvorgänge Multilagenschichten mit jeweils unterschiedlichen Schichteigenschaften abzuscheiden, beispielsweise eine Abfolge von hydrophilen und hydrophoben Schichten, um höhere Abrasionsbeständigkeit der Beschichtung oder niedrigere Schichtkorrosion zu erreichen. Wird etwa ein Precursor auf Siloxanbasis als Beschichtungsmaterial verwendet und über die Zuführeinrichtung 15 im gasförmigen Zustand bei hoher Schrägstellung des Zufuhrrohres 13, also nahe der Ausströmöffnung 9, dem Ausströmbereich 14 des Plasmastrahls zugeführt, erfolgt eine Abscheidung vorwiegend als hydrophile Schicht, während bei einer Zufuhr des dampfförmigen Precursors bei niedrigem Zufuhrwinkel α zwischen der Zufuhrachse Z und der Längsachse des Austrittskanals 4, also in vergleichsweise größerer Entfernung von der Ausströmöffnung 9, die Abscheidung vorwiegend als hydrophobe Schicht erfolgt. Als Substrat können dabei metallische Werkstoffe, aber auch Kunststoffe, insbesondere Thermoplasten, verwendet werden, da aufgrund des indirekt übertragenen Lichtbogens sowohl elektrisch leitfähige als auch nicht-leitfähige Substrate wie glasartige Werkstoffe, Verbundwerkstoffe (CFK/GFK), Kunststoffe und/oder Papier/Karton beschichtet werden können. Der durch die erfindungsgemäße Vorrichtung mögliche Multilagenaufbau von Beschichtungen ermöglicht etwa auch das Einschmelzen metallischer Partikel in die Oberfläche von Thermoplasten, um dadurch eine feste Partikelverankerung zu erzielen. Auf diese Weise kann ein frühzeitiger abrasiver Verschleiß der Beschichtung verringert werden.

Mithilfe der örtlichen Verstellbarkeit der Injektion des Beschichtungsmaterials in den Plasmastrahl gelingt es dabei insbesondere, die funktionalen Eigenschaften der Beschichtung homogener und besser kontrollierbar zu gestalten, wodurch das Aufbringen einer Schicht auf der Substratoberfläche mittels eines Plasmastrahls unter atmosphärischen Bedingungen verbessert wird.

### Bezugszeichenliste:

- 1: Plasmaerzeuger
- 2: Kathode
- 3: konischer Endbereich
- 4: Austrittskanal
- 5: Anode
- 6: Spannungsquelle
- 7: Arbeitsgaskanal
- 8: Arbeitsgasquelle
- 9: Ausströmöffnung
- 10: Kühlmittelkanäle
- 11: Kühlmittelquelle
- 12: Halterung
- 13: Zufuhrrohr
- 14: Ausströmbereich
- 15: Verdampfer
- 16: Austrittsöffnung
- 17: Vorratsbehälter
- Z: Zufuhrachse des Beschichtungsmaterials

## Patentansprüche

1. Vorrichtung zum Aufbringen einer Beschichtung auf eine Oberfläche eines Substrats mit einem Plasmaerzeuger (1) umfassend eine Anode (5) und eine Kathode (2) zum Erzeugen eines atmosphärischen Plasmastrahls durch elektrische Entladung in einem Arbeitsgas, wobei eine Zufuhreinrichtung mit einer Einlassseite zum Beschicken der Zufuhreinrichtung mit einem Beschichtungsmaterial und einer Auslassseite zum Einbringen des Beschichtungsmaterials in den Plasmastrahl vorgesehen ist, und die Zufuhreinrichtung einlassseitig mit einem Verdampfer (15) für das Beschichtungsmaterial verbunden ist und auslassseitig eine Austrittsöffnung (16) für das gasförmige Beschichtungsmaterial aufweist, **dadurch gekennzeichnet, dass** der Plasmaerzeuger (1) einen Austrittskanal (4) für den Plasmastrahl aufweist, der sich über eine Ausströmöffnung (9) zur umgebenden Atmosphäre öffnet, an die sich ein Ausströmbereich (14) des in die umgebende Atmosphäre austretenden Plasmastrahls anschließt, und die Zufuhreinrichtung als zumindest ein Zufuhrrohr (13) ausgeführt ist, dessen Austrittsöffnung (16) in den Ausströmbereich (14) gerichtet und innerhalb des Plasmastrahls positioniert ist.

2. Vorrichtung nach Anspruch 1, **dadurch gekennzeichnet, dass** die Zufuhreinrichtung als zumindest ein Zufuhrrohr (13) ausgeführt ist, das auf einer Halterung (12) am Plasmaerzeuger (1) befestigt ist.

3. Vorrichtung nach Anspruch 2, **dadurch gekennzeichnet, dass** das Zufuhrrohr (13) an der Halterung (12) verstellbar befestigt ist.

4. Vorrichtung nach Anspruch 2 oder 3, **dadurch gekennzeichnet, dass** die durch die Längsachse des Zufuhrrohres (13) definierte Zufuhrrichtung des Beschichtungsmaterials in einem spitzen Winkel (α) zu der durch die Längsachse des Austrittskanals (4) definierten Ausströmrichtung des Plasmagases angeordnet ist.

## Claims

1. Device for applying a coating to a surface of a substrate having a plasma generator (1), comprising an anode (5) and a cathode (2) for generating an atmospheric plasma jet by electrical discharge in a working gas, wherein a feed apparatus having an inlet side for feeding a coating material to the feed apparatus and an outlet side for introducing the coating material into the plasma jet is provided, and the feed apparatus is connected on the inlet side to an evaporator (15) for the coating material and on the outlet side has an outlet opening (16) for the gaseous coating material, **characterized in that** the plasma generator (1) has an outlet channel (4) for the plasma jet, which opens to the surrounding atmosphere via an outflow opening (9), to which an outflow region (14) of the plasma jet emerging into the surrounding atmosphere adjoins, and the feed apparatus is designed as at least one feed pipe (13) having an outlet opening (16) which is directed into the outflow region (14) and positioned within the plasma jet.

2. Device according to claim 1, **characterized in that** the feed apparatus is designed as at least one feed pipe (13) which is fastened on a holder (12) on the plasma generator (1).

3. Device according to claim 2, **characterized in that** the feed pipe (13) is adjustably mounted on the holder (12).

4. Device according to claim 2 or 3, **characterized in that** the feed direction of the coating material defined by the longitudinal axis of the feed pipe (13) is arranged at an acute angle (α) to the outflow direction of the plasma gas, which is defined by the longitudinal axis of the outlet channel (4).

## Revendications

1. Dispositif pour l'application d'un revêtement sur une surface d'un substrat avec un générateur de plasma (1) comprenant une anode (5) et une cathode (2) pour produire un jet de plasma atmosphérique par une décharge électrique dans un gaz de travail, dans lequel est prévue une installation d'alimentation avec un côté d'entrée pour charger l'installation d'alimentation avec un matériau de revêtement et un côté de sortie pour introduire le matériau de revêtement dans le jet de plasma, et l'installation d'alimentation est reliée du côté de l'entrée à un évaporateur (15) pour le matériau de revêtement et comporte du côté de la sortie une ouverture de sortie (16) pour le matériau de revêtement gazeux, **caractérisé en ce que** le générateur de plasma (1) présente un canal de sortie (4) pour le jet de plasma qui s'ouvre vers l'atmosphère environnante, par une ouverture de sortie (9) qui est suivie d'une zone de sortie (14) pour le jet de plasma qui s'échappe dans l'atmosphère environnante, et l'installation d'alimentation est réalisée comme au moins un tuyau d'arrivée (13) dont l'ouverture de sortie (16) est orientée dans la zone de sortie (14) et positionnée à l'intérieur du jet de plasma.

2. Dispositif selon la revendication 1, **caractérisé en ce que** l'installation d'alimentation est réalisée comme au moins un tuyau d'arrivée (13) qui est fixé sur une monture (12) sur le générateur de plasma (1).

3. Dispositif selon la revendication 2, **caractérisé en ce que** le tuyau d'arrivée (13) est fixé de façon réglable sur la monture (12).

4. Dispositif selon la revendication 2 ou 3, **caractérisé en ce que** la direction d'arrivée du matériau de revêtement définie par l'axe longitudinal du tuyau d'arrivée (13) est disposée sous un angle aigu (α) par rapport au sens de sortie du gaz plasmagène défini par l'axe longitudinal du canal de sortie (4).
